# EUROPEAN PATENT SPECIFICATION

(11) **EP 2 625 240 B1**
(45) Date of publication and mention of the grant of the patent: **29.06.2016**
(21) Application number: 11782691.7
(22) Date of filing: 05.10.2011
(51) Int. Cl.: C09K 3/14, H01L 31/00, B28D 5/00, H01L 31/18, B28D 1/02

(54) **A METHOD FOR PRODUCTION OF PHOTOVOLTAIC WAFERS AND ABRASIVE SLURRY**
VERFAHREN ZUR HERSTELLUNG VON PV-WAFERN UND SCHLEIFSUSPENSION
PROCÉDÉ POUR LA PRODUCTION DE TRANCHES PHOTOVOLTAÏQUES ET SUSPENSION CONCENTRÉE ABRASIVE

(30) Priority: 08.10.2010 US 391136 P; 08.10.2010 GB 201017049
(43) Date of publication of application: 14.08.2013
(73) Proprietor: REC Solar Pte. Ltd., Singapore 637312 (SG)
(72) Inventor: MENON, Mohan, NO-3929 Porsgrunn Norway (NO); LOHNE, Anne, N-3939 Porsgrunn (NO); SAUAR, Erik, N-0372 Oslo (NO); SANNES, Stian, N-3730 Drangedal (NO)
(74) Representative: Onsagers AS
(86) International application number: PCT/NO2011/000284
(87) International publication number: WO 2012/047114

(56) References cited:
- EP-A1- 1 369 906
- US-A1- 2006 213 868
- US-A1- 2008 102 735

## Description

### Field of technology

The present invention relates to abrasives slurries for multi-wire sawing of wafers for photovoltaic applications, and more specific to abrasive slurries which are easy to remove from the wafers after sawing.

### Background

The main volume of present industrial production of photovoltaic modules is based on wafers of semiconductor material which are processed to solar cells electrically stringed together to form modules. Wafers of various materials may be employed, such as i.e. Si, or GaAs. The wafers may be formed in high volumes by slicing them out of a crystalline block of the semiconductor material by use of a wire saw, which is a web or multi wire array of rapidly moving wires such as disclosed in i.e. GB 2414204.

The wire saw may apply a free abrasive consisting of an abrasive material such as SiC, BC, corundum or other abrasives suspended in a carrier liquid such as polyethylene glycol (PEG) (mol. wt. < 300), polypropylene glycol (PPG), or mixtures thereof. For instance, in case of cutting silicon wafers, the crystalline block will typically be cut by a silicon carbide (SiC) - polyethylene glycol slurry (free abrasive slurry) carried into the block by the sawing wires moving into the block at speeds of 5 - 20 m/s.

The aim of efficient sawing is to cut high quality wafers from a block of semiconductor material at low cost with a high throughput and a minimum loss of slurry and silicon. The quality of sawn wafers; thickness variations, saw marks, stains on the surface etc depends more or less on the properties of the abrasive slurry and the semiconductor block. It is common in the industry to collect the used slurry and separate the solid and liquid parts and subsequently recycle the fractions of abrasives and carrier liquids that are within specifications. New abrasive slurry is prepared using fractions of new and recycled abrasive and carrier liquid fractions. This is important both from a cost perspective and waste management perspective.

Another consideration which needs to be taken into account is the drive towards producing thinner wafers in the photovoltaic industry in order to alleviate the problem of low utilisation of the crystalline photovoltaic material. However, thin wafers (thickness < 200 µm) are considerably more fragile than previous wafers of around 300 µm in thickness, such that the use of thin wafers requires a considerably more gentle handling of the wafers in the process line to avoid excessive losses due to breaking in the subsequent processing to solar cells. One particularly process step where the fragility of the wafers is a restriction, is the cleaning or removal of particulates and abrasive slurry from the surface of the wafers after sawing. The wafers do not tolerate too strong cleaning/washing such that wafers with too much kerf remains and abrasive slurry or where the slurry adheres too strong to the wafers surface, must be rejected because the dirt on the surface of wafers depreciates the efficiency of the solar cells.

### Prior art

It is known from US 6 568 384 that adding an aqueous solution of KOH or NaOH of 2 % or less, to a mixture of free abrasive particles in an oil- or water based slurry in a wire sawing of photovoltaic materials, results in reduced residual distortion, cutting heat, and process stress and thus allowing obtaining high-precision wafers. The oil-based slurry may be a mineral oil, and the water based slurry may be polyethylene glycol. The free abrasives may be SiC, BC, or GC.

From CN101560430A it is known a fully synthetic cutting fluid which comprises anion active agent, non-ionic surface active agent, polyethylene glycol, borax, bactericide, foam suppressor, pH regulator, water and additive. The additive is prepared by the following method: the surface active agents are dissolved by acetone, the mixed solution is added with toluene and heated up to 50 - 60 °C, and the reaction system is dripped with acrylate monomer as well as azodiisobutyronitrile (AIBN) or ammonium per-sulphate (APS) evocating agent; after that, the temperature is preserved for 3 - 5 hours, the reaction stops, and organic solvent is removed, so that the additive is obtained. Compared with the existing fully synthetic cutting fluid, the fully synthetic cutting fluid of the invention can completely inhibit leaching of cobalt element in hard alloy containing cobalt when metal is processed, as well as solving the problem of separating the cobalt in the existing fully synthetic cutting fluid, and is environment-friendly and efficient.

From EP 1674558 it is known a slurry for cutting a silicon ingot, where the slurry has a content of a basic material of at least 3.5 % by mass with respect to the total mass of a liquid component of a slurry, and organic amine in a mass ratio of 0.5 to 5.0 with respect to water in a liquid component of the slurry, and the pH of the slurry is 12 or more. The slurry may be used for cutting a silicon ingot at 65 to 95 °C, and provides a reduced cutting resistance and wafers of high quality.

From WO 2009/134236 it is known a cutting and lubricating suspension composition containing gelatinous particles for cutting hard and brittle material with a wire saw. The composition contains an in situ partially neutralized polyelectrolyte and a glycol which suspends abrasive particles used in the cutting operation. More specifically, the lubricating composition, which may contain up to about 70% (wt/wt) of an abrasive material preferably, comprises the steps of admixing at a temperature below about 35 °C:
a) about 0.0 to 10 % by weight of a non-ionic surfactant
b) about 80 to 99 weight percent of a polyalkylene glycol having 2 - 5 carbon atoms or the co-glycols thereof, and
c) about 0.3 to 6 % weight percent of an organic ionic polyelectrolyte and then partially neutralizing the polyelectrolyte with an appropriate Bronsted base to a pH of about 4.0 to 5.5 so as to form gelatinous micro-particles.

### Objective of the invention

The main objective of the invention is to provide a method and abrasive slurry for cost effective manufacturing of photovoltaic wafers.

A further objective of the invention is to provide a method for cost effective high-quality production of photovoltaic wafers by wire sawing providing wafers which are easy to clean after sawing.

### Description of the invention

The invention is based on the observation that the abrasive slurry employed in production of photovoltaic wafers achieved excellent properties enabling high quality sawing precision combined with low adhesiveness of the abrasive slurry alleviating the subsequent washing process to a degree resulting in lower reject rates and consequently higher productivity and lower cost, if both the pH and the ion content in the abrasive slurry is monitored and eventually regulated to be within a specific window.

Thus in a first aspect, the present invention relates to a method for production of photovoltaic wafers, comprising:
- sawing out the wafers out from a block of crystalline photovoltaic material by using a wire saw, where the sawing effect is provided by the wire together with an abrasive slurry comprising abrasive particles and a polar organic fluid as carrier and/or coolant fluid, and
- wherein the abrasive slurry is a mixture made by mixing one part of recycled abrasive slurry and one part of novel abrasive slurry, and wherein
- the pH of the abrasive slurry mixture is adjusted to be within 6.0 to 9.0 by adding an alkali to the mixture,
- the ionic content of the abrasive slurry mixture is controlled by measuring the electric conductance of the abrasive slurry mixture, and
- regulated to a value resulting in an electric conductance below 50 µS/cm.

In a second aspect, the invention relates to an abrasive slurry mixture for use in wire sawing of photovoltaic wafers, wherein the abrasive slurry mixture comprises:
- one part recycled abrasive slurry,
- one part alkali, and
- one part novel abrasive slurry in an amount sufficient to provide an ion content in the abrasive slurry mixture to provide an electric conductivity of less than 50 µS/cm and a pH in the abrasive slurry mixture in the range from 6.0 to 9.0,

- wherein the abrasive slurry being employed is a polar organic liquid with free abrasive particles, and
- the polar organic liquid is one or more of the following liquids; polyethylene glycol (PEG), polypropylene glycol (PPG), co polymers of various polyalkylene oxides, and polyalkylene glycol (PAG), and
- the free abrasive particles are one or more of the following abrasive particles; aluminium oxide (corundum), silicon carbide (SiC), boron carbide (BC), and gallium carbide.

The addition of both the alkali and the novel abrasive slurry should be made to obtain both a pH in the mixture in the range from 6.0 - 9.0 and an ion content resulting in an electric conductance below 50 µS/cm. Thus it may be necessary to add more alkali to the mixture after the addition of the novel abrasive slurry in the method according to the first aspect of the invention.

The term "abrasive slurry" as used herein means any known or conceivable polar organic liquid containing abrasive particles which will function as a lubricant and/or coolant for the cutting wire being employed to sawing wafers out of a block of photovoltaic material. The abrasive particles in the abrasive slurry may be free particles which are freely floating in the liquid or adhered to the surface of the cutting wire. The term "novel abrasive slurry" as used herein means any abrasive slurry which has not been employed for sawing wafers, that is, the novel abrasive slurry is a fresh slurry obtained by mixing abrasive particles plus eventual other additives with the polar organic liquid. The specification for the organic novel abrasive slurry is that it should contain less than 0.5 weight% water.

Sawing of wafers is a batch process and at the end of the sawing, once the wafers have been created, the slurry is collected and termed as "used abrasive slurry". The term "recycled abrasive slurry" as used herein means sawing slurry made by abrasive particles and polar organic liquid being recovered from used abrasive slurry. The recovery of the organic liquid and abrasive particles from used slurries may be obtained by any known method. Examples of such are given in i.e. WO 2008/078349, US 6 231 628, US 7 223 344, WO 2006/137098, or WO 02/40407. These documents describe a method to extract SiC and the organic liquid for reuse from used abrasive slurries. The organic polar liquid recovered from used abrasive slurries will usually contain remains from the sawing process such as water (1 - 2 weight%) and dissolved remains of abraded steel wire (the sawing wire); Fe, Cu, Zn, Cr and other materials. Thus there will be some water with a relative high ion content left in the recycled liquid fraction. The term "abrasive slurry mixture" as used herein means a mixture of at least one part recycled used abrasive slurry, one part novel abrasive slurry, and one part of a base. That is, the the abrasive slurry mixture is prepared by adding virgin abrasive material, virgin polar organic liquid, recycled abrasive material (from used slurry), recycled polar organic liquid (from used slurry) along with an alkali. The abrasive slurry mixture may contain one or more of any other conceivable compounds known to a skilled person for tailoring the properties of abrasive slurries.

Examples of liquids suited for use in the abrasive slurry includes polyethylene glycol (PEG), polypropylene glycol (PPG), co polymers of various polyalkylene oxides and polyalkylene glycol (PAG) or a mixture of two or more of these. Examples of abrasive particles suited for use abrasive slurry includes crystalline particles of aluminium oxide (corundum), silicon carbide (SiC), boron carbide (BC), and gallium carbide or a mixture of two or more of these.

The term "alkali" as used herein means any chemical compound which may accept hydronium ions (H⁺-ions), and thus cause an increase in the pH of the abrasive slurry. Examples of suitable compounds to be used as alkali in the invention includes, but are not limited to, hydroxides of alkali or alkaline earth metals, such as NaOH, KOH, LiOH, Ca(OH)₂, Mg (OH)₂ or a mixture of two or more of these. The alkali may be added to the abrasive slurry in the form of an aqueous solution. In the case of a strong mineral base, such as KOH, typical amounts added to the abrasive slurry will be in the range from about 10 to about 500 ppmw, often in the range from 10 to 100 ppmw. Other alkali compounds should be added in equivalent amounts.

Conductivity and pH of the abrasive slurry may be determined by the following process:
1. 10 g abrasive slurry is mixed with 90 g of de-ionized water (ASTM type 1) and a glass electrode is used to read the pH with a pH meter under weak stirring.
2. 10 g abrasive slurry is mixed with 90 g of de-ionized water (ASTM type 1) and a conductivity electrode (electrode known to persons skilled in the art) is used to read the conductivity (in micro Siemens per cm (µS/cm)) under weak stirring.

The term "wafer" as used herein means a disk or planar sheet of any type of mono-, micro-, or multi-crystalline semiconductor material which may be processed to form photovoltaic cells. The thickness of the wafer is not vital; any thickness may be applied, but will in practice be from about 100 to about 250 µm. Examples of suitable materials include, but are not limited to Si or GaAs.

The invention may be considered as a practical implementation based on the observation that when employing basic sawing slurries which provide excellent sawing quality, there is found a correlation between the stickiness (adhesion) of the sawing slurry to the surface of the wafers and the ion content in the slurry. The higher ion content in the slurry, the more abrasive slurry and cations present in the slurry will be adhered to the wafers and the stronger is the adherence observed to be.

However, removing the remains of the abrasive slurry from the wafer surfaces is of critical importance because the surface of the wafers needs to be free of contaminants to below the ppm-level in order to make high-efficient photovoltaic cells. Thus, the stickiness of the abrasive slurry is a serious problem for state of the art wafer based photovoltaic industry because wafers have become so thin and fragile that they tend to break apart during the required strong cleaning process for removing relatively huge amounts of strongly adhered abrasive slurry. This problem will only be worsened by future wafer based production due to the industry's drive towards thinner and thinner wafers.

Thus the invention becomes a trade-off between the need for high-precision sawing caused by employing sawing slurries with high pH-values, and the need for simplifying the cleaning process of the wafers by avoiding too heavy adhesion of the abrasive slurry caused by ions in the slurry. The main sources for ions in the abrasive slurry are usually the alkali compounds added to provide the intended pH-value and ionic remains included in the novel and recycled abrasives and carrier liquids fractions of the abrasive slurry. For novel abrasive slurries which initially have low ion contents and high pH, there will normally not be a problem with too high ion contents due to the addition of the alkali compounds. The problem of dirt-stickiness on the wafers are usually observed in cases where the abrasive slurry is a mixture of one part recycled abrasive slurry (which in practice will contain ionic residues) and one part novel abrasive slurry. It is in these cases that the monitoring of the ion content and eventual dilution of the abrasive slurry by adding more novel (low ion content) abrasive slurry becomes important.

The operation windows which have been found to provide the advantageous combination of high-precision sawing and easy-cleaning of the abrasive slurry are any possible combination of one of the following pH-ranges from 6.0 to 9.0; from 6.0 to 8.0; from 6.0 to 7.0; from 6.5 to 9.0; from 6.5 to 8.0; from 6.5 to 7.0; from 7.0 to 9.0; from 7.0 to 8.0; from 7.0 to 7.5; from 7.5 to 9.0; from 7.5 to 8.0; from 8.0 to 9.0; and from 8.0 to 8.5, with one of the following electric conductivities of the abrasive slurry of less than 50 µS/cm; less than 45 µS/cm; less than 40 µS/cm; less than 35 µS/cm; less than 30 µS/cm; less than 25 µS/cm; and less than 20 µS/cm.

### List of figures

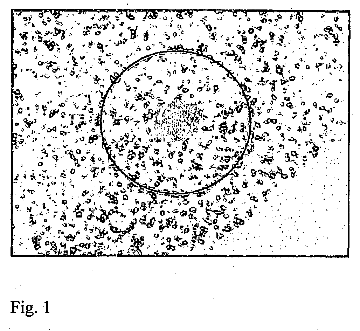

Figure 1 is a photograph showing an example of a polycrystalline with unacceptable high dirt adherence after sawing, the dirt is in the area marked with a ring.

### Example embodiment of the invention

The invention will now be described in greater detail by way of example embodiments and comparison experiments verifying the claimed effect of the invention. These examples should however, not be interpreted as a limitation of the scope of the invention as defined in the first and second aspect above.

### First example embodiment

This example is an embodiment of the invention where a block of silicon is sawn into 180 µm thick wafers. The saw is set up in a way known per se to a skilled person and the block may be sawn into a maximum number of 2800 wafers. The wire was fed abrasive slurry of polyethylene glycol with free abrasive particles of SiC, and the pH and ion content of the abrasive slurry was kept within the specified window according to the first aspect of the invention.

The abrasive slurry was made as follows: SiC F800 (according to FEPA-Standard 42-2:2006) and PEG 200 (polyethylene glycol with an average molecular weight of 200 Daltons) were mixed together in a ratio of 46.7 wt% SiC and 53.3 wt% PEG 200 such that the density of the resulting slurry was 1.61 g/ml. The pH of the slurry was measured by mixing the 10 ml of slurry in 90 ml DI water using a glass electrode. The pH was found to be 5.8. Then 50 ppm KOH was added (45 wt% aqueous solution) such that the pH after mixing was 7.1. The conductivity of the slurry was also measured by mixing 10 ml slurry in 90 ml water. The conductivity of the slurry increased from 15 µS/cm to 25 µS/cm after addition of 50 ppm KOH.

After cutting of the wafers, it was found that 32 wafers from the block was too dirty and had to be rejected, giving a reject rate of about 1.1 %.

### Second example embodiment

This example is an embodiment similar to the first example embodiment in that a block of polycrystalline silicon is sawn into a maximum number of 2800 silicon wafers with a thickness of 180 µm. The wire was fed abrasive slurry of polyethylene glycol with free abrasive particles of SiC, and the pH and ion content of the abrasive slurry was kept within the specified window according to the first aspect of the invention.

The abrasive slurry was made as follows: SiC F600 (according to FEPA-Standard 42-2:2006) and PEG 200 (polyethylene glycol with an average molecular weight of 200 Daltons) were mixed together in a ratio of 46.7 wt% SiC and 53.3 wt% PEG 200 such that the density of the resulting slurry was 1.61 g/ml. The pH of the slurry was measured by mixing the 10 ml of slurry in 90 ml DI water using a glass electrode. The pH was found to be 5.3. Then 50 ppm KOH was added (45 wt% aqueous solution) such that the pH after mixing was 6.8. The conductivity of the slurry was also measured by mixing 10 ml slurry in 90 ml water. The conductivity of the slurry increased from 15 µS/cm to 22 µS/cm after addition of 50 ppm KOH. After cutting of the wafers, it was found that about 15 wafers of the wafers was too dirty and had to be rejected, giving a reject rate of about 0.5 %.

### Third example embodiment

This example is an embodiment similar to the first example embodiment in that a block of polycrystalline silicon is sawn into a maximum number of 2800 silicon wafers with a thickness of 180 µm. The wire was fed abrasive slurry of polyethylene glycol with free abrasive particles of SiC, and the pH and ion content of the abrasive slurry was kept within the specified window according to the first aspect of the invention.

The abrasive slurry was made as follows: SiC F600 (according to FEPA-Standard 42-2:2006) and PEG 300 (polyethylene glycol with an average molecular weight of 300 Daltons) were mixed together in a ratio of 46.7 wt% SiC and 53.3 wt% PEG 300 such that the density of the resulting slurry was 1.61 g/ml. The pH of the slurry was measured by mixing the 10 ml of slurry in 90 ml DI water using a glass electrode. The pH was found to be 5.6. Then 30 ppm KOH was added (45 wt% aqueous solution) such that the pH after mixing was 6.9. The conductivity of the slurry was also measured by mixing 10 ml slurry in 90 ml water. The conductivity of the slurry increased from 15 µS/cm to 19 µS/cm after addition of 30 ppm KOH.

After cutting of the wafers, it was found that about 0.6 % (20 wafers) of the wafers was too dirty and had to be rejected, giving a reject rate of about 0.6 %.

### Fourth example embodiment

This example is an embodiment similar to the first example embodiment in that a block of polycrystalline silicon is sawn into a maximum number of 2800 silicon wafers with a thickness of 180 µm. The wire was fed abrasive slurry of polypropylene glycol with free abrasive particles of SiC, and the pH and ion content of the abrasive slurry was kept within the specified window according to the first aspect of the invention.

The abrasive slurry was made as follows: SiC F600 (according to FEPA-Standard 42-2:2006) and PPG 200 (polypropylene glycol with an average molecular weight of 200 Daltons) were mixed together in a ratio of 46.7 wt% SiC and 53.3 wt% PPG 200 such that the density of the resulting slurry was 1.61 g/ml. The pH of the slurry was measured by mixing the 10 ml of slurry in 90 ml DI water using a glass electrode. The pH was found to be 5.8. Then 20 ppm KOH was added (45 wt% aqueous solution) such that the pH after mixing was 7.1. The conductivity of the slurry was also measured by mixing 10 ml slurry in 90 ml water. The conductivity of the slurry increased from 15 µS/cm to 20 µS/cm after addition of 20 ppm KOH. After cutting of the wafers, it was found that about 20 wafers was too dirty and had to be rejected, giving a reject rate of about 0.6 %.

### Fifth example embodiment

This example is an embodiment similar to the first example embodiment in that a block of polycrystalline silicon is sawn into a maximum number of 2800 silicon wafers with a thickness of 180 µm. The wire was fed abrasive slurry of polyethylene glycol with free abrasive particles of SiC, and the pH and ion content of the abrasive slurry was kept within the specified window according to the first aspect of the invention.

The abrasive slurry was made as follows: SiC F800 (according to FEPA-Standard 42-2:2006) and PEG 200 (polyethylene glycol with an average molecular weight of 200 Daltons) were mixed together in a ratio of 46.7 wt% SiC and 53.3 wt% PEG 200 such that the density of the resulting slurry was 1.61 g/ml. The SiC fraction of the slurry consisted of 50% virgin SiC and 50% recycled SiC (from used slurry), whereas the PEG fraction consisted of 10% virgin and 50% recycled (from used slurry) fraction. The pH of the slurry was measured by mixing the 10 ml of slurry in 90 ml DI water using a glass electrode. The pH was found to be 5.8. Then 50 ppm KOH was added (45 wt% aqueous solution) such that the pH after mixing was 7.1. The conductivity of the slurry was also measured by mixing 10 ml slurry in 90 ml water. The conductivity of the slurry increased from 15 µS/cm to 25 µS/cm after addition of 50 ppm KOH.

After cutting of the wafers, it was found that 32 wafers from the block was too dirty and had to be rejected, giving a reject rate of about 1.1 %.

### Comparison example 1

This example illustrates the effect of employing an abrasive slurry on the same type of wafers and abrasive slurry as in the first example embodiment above, but with too low pH and an ion level within the specified window of the invention in the abrasive slurry.

The abrasive slurry was made as follows: SiC F800 and PEG 200 were mixed together in a ratio of 46.7 wt% SiC and 53.3 wt% PEG such that the density of the resulting slurry was 1.61 g/ml. The pH of the slurry was measured by mixing the 10 ml of slurry in 90 ml DI water using a glass electrode. The pH was found to be 5.4 and the conductivity 15 µS/cm.

After cutting of the wafers, it was found that about 60 % of the wafers were too dirty and had to be rejected, giving a dramatic increase in the reject rate of the wafer production.

### Comparison example 2

This example illustrates the effect of employing an abrasive slurry on the same type of wafers and abrasive slurry as in the example embodiment above, but with a pH-level within the specified window of the invention and a too high ion content in the abrasive slurry.

The abrasive slurry was made as follows: SiC F800 and PEG 200 were mixed together in a ratio of 46.7 wt% SiC and 53.3 wt% PEG such that the density of the resulting slurry was 1.61 g/ml. The pH of the slurry was measured by mixing the 10 ml of slurry in 90 ml DI water using a glass electrode. The pH was found to be 5.1. 550 ppm KOH was added (45 wt% aqueous solution) such that the pH after mixing was 7.1. The conductivity of the slurry was also measured by mixing 10 ml slurry in 90 ml water. The conductivity of the slurry increased from 15 µS/cm to 75 µS/cm after addition of 550 ppm KOH.

After cutting of the wafers, it was found that about 80 % of the wafers were too dirty and had to be rejected, giving a dramatic increase in the reject rate of the wafer production.

The comparison examples show that the dirtiness of the wafers after sawing is strongly dependent on both the pH and the ion content of the abrasive slurry, and that the reject rates may become unacceptably increased due to strong adhesion of sawing remains, ions, and abrasive slurry without having control on the pH and ion content of the abrasive slurry. The threshold being employed as too dirty in these examples is that at least 5 % of the surface of the wafers is covered with dirt after sawing. An example of a too dirty wafer is shown in Figure 1 which is a photograph of a polycrystalline silicon wafer. The dirty region is marked with a ring.

## Claims

1. A method for production of photovoltaic wafers comprising,
- sawing out the wafers out from a block of crystalline photovoltaic material by using a wire saw, where the sawing effect is provided by the wire together with an abrasive slurry comprising abrasive particles and a polar organic liquid as carrier and/or coolant fluid,
- wherein the abrasive slurry is a mixture made by mixing one part of recycled abrasive slurry and one part of novel abrasive slurry, and wherein
- the pH of the abrasive slurry mixture is monitored and adjusted to be within 6.0 to 9.0 by adding an alkali to the mixture,
- the ionic content of the abrasive slurry mixture is controlled and monitored by measuring the electric conductance of the abrasive slurry mixture, and
- the ionic content is regulated to a value resulting in an electric conductance below 50 µS/cm.

2. A method according to claim 1, wherein the amount of recycled abrasive slurry, novel abrasive slurry and alkali compound being mixed is adjusted to provide a pH and the ion content of the abrasive slurry of any possible combination of one of the following pH-ranges from 6.0 to 9.0; from 6.0 to 8.0; from 6.0 to 7.0; from 6.5 to 9.0; from 6.5 to 8.0; from 6.5 to 7.0; from 7.0 to 9.0; from 7.0 to 8.0; from 7.0 to 7.5; from 7.5 to 9.0; from 7.5 to 8.0; from 8.0 to 9.0; and from 8.0 to 8.5, with one of the following electric conductivities of the abrasive slurry of less than 50 µS/cm; less than 45 µS/cm; less than 40 µS/cm; less than 35 µS/cm; less than 30 µS/cm; less than 25 µS/cm; and less than 20 µS/cm.

3. A method according to claim 1 or 2, wherein the abrasive slurry being employed is a polar organic liquid with free abrasive particles.

4. A method according to claim 3, wherein the polar organic liquid is one or more of the following liquids; polyethylene glycol (PEG), polypropylene glycol (PPG), co polymers of various polyalkylene oxides, and polyalkylene glycol (PAG) and one or more of the following abrasive particles; aluminium oxide (corundum), silicon carbide (SiC), boron carbide (BC) and gallium carbide.

5. A method according to claim 1 or 2, wherein the alkali compound being added is one or more of hydroxides of alkali or alkaline earth metals, such as NaOH, KOH, LiOH, Ca(OH)₂, Mg (OH)₂.

6. A method according to claim 1 or 2, wherein the wafer being employed is either mono-, micro-, or multi-crystalline with a thickness in the range from about 100 to about 250 µm, and are made of one of; Si or GaAs.

7. A method according to any of the preceding claims, wherein the ionic content is regulated to a value resulting in an electric conductance below 50 µS/cm by adding more novel abrasive slurry to the abrasive slurry mixture if needed.

8. Abrasive slurry mixture for use in wire sawing of photovoltaic wafers, wherein the abrasive slurry mixture comprises:
- one part recycled abrasive slurry,
- one part alkali, and
- one part novel abrasive slurry in an amount sufficient to provide an ion content in the abrasive slurry mixture to provide an electric conductivity of less than 50 µS/cm and a pH in the abrasive slurry mixture in the range from 6.0 to 9.0,
- wherein the abrasive slurry being employed is a polar organic liquid with free abrasive particles, and
- the polar organic liquid is one or more of the following liquids; polyethylene glycol (PEG), polypropylene glycol (PPG), co polymers of various polyalkylene oxides, and polyalkylene glycol (PAG), and
- the free abrasive particles are one or more of the following abrasive particles; aluminium oxide (corundum), silicon carbide (SiC), boron carbide (BC), and gallium carbide.

9. Abrasive slurry mixture according to claim 8, wherein the pH and the ion content of the abrasive slurry is any possible combination of one of the following pH-ranges from 6.0 to 9.0; from 6.0 to 8.0; from 6.0 to 7.0; from 6.5 to 9.0; from 6.5 to 8.0; from 6.5 to 7.0; from 7.0 to 9.0; from 7.0 to 8.0; from 7.0 to 7.5; from 7.5 to 9.0; from 7.5 to 8.0; from 8.0 to 9.0; and from 8.0 to 8.5, with one of the following electric conductivities of the abrasive slurry of less than 50 µS/cm; less than 45 µS/cm; less than 40 µS/cm; less than 35 µS/cm; less than 30 µS/cm; less than 25 µS/cm; and less than 20 µS/cm.

10. Abrasive slurry mixture according to claim 8 or 9, wherein
- the abrasive slurry is polyethylene glycol with an average molecular weight of 200 Daltons and SiC-particles in size distribution F800 according to FEPA-Standard 42-2:2006 and/or F600 according to FEPA-Standard 42-2:2006, and
- the alkali is from 10 to 500 ppmw KOH.

## Patentansprüche

1. Verfahren zur Herstellung von Fotovoltaik-Wafern, Folgendes umfassend:
- Aussägen der Wafer aus einem Block kristallinen Fotovoltaikmaterials unter Verwendung einer Drahtsäge, wobei die Sägewirkung durch den Draht zusammen mit einem abrasiven Schlamm bereitgestellt wird, der abrasive Partikel und eine polare organische Flüssigkeit als Träger- und/oder Kühlmittelfluid umfasst,
- wobei der abrasive Schlamm ein Gemisch ist, das durch Mischen eines Teils eines recycelten abrasiven Schlamms und eines Teils neuwertigen abrasiven Schlamms hergestellt wird, und wobei
- der pH-Wert des abrasiven Schlammgemischs überwacht und auf innerhalb von 6,0 bis 9,0 eingestellt wird, indem dem Gemisch ein Alkali zugesetzt wird,
- der Ionengehalt des abrasiven Schlammgemischs gesteuert und überwacht wird, indem der elektrische Leitwert des abrasiven Schlammgemischs gemessen wird, und
- der Ionengehalt auf einen Wert geregelt wird, der zu einem elektrischen Leitwert von unter 50 µS/cm führt.

2. Verfahren nach Anspruch 1, wobei die Menge an recyceltem abrasiven Schlamm, neuwertigem abrasiven Schlamm und Alkaliverbindung, die gemischt wird, zum Bereitstellen eines pH-Werts und des Ionengehalts des abrasiven Schlamms irgendeiner möglichen Kombination eines der folgenden pH-Bereiche von 6,0 bis 9,0; von 6,0 bis 8,0;von 6,0 bis 7,0; von 6,5 bis 9,0;von 6,5 bis 8,0; von 6,5 bis 7,0; von 7,0 bis 9,0; von 7,0 bis 8,0; von 7,0 bis 7,5; von 7,5 bis 9,0; von 7,5 bis 8,0; von 8,0 bis 9,0; und von 8,0 bis 8,5, mit einer der folgenden elektrischen Leitfähigkeiten des abrasiven Schlamms von weniger als 50 µS/cm; weniger als 45 µS/cm; weniger als 40 µS/cm; weniger als 35 µS/cm; weniger als 30 µS/cm; weniger als 25 µS/cm; und weniger als 20 µS/cm eingestellt wird.

3. Verfahren nach Anspruch 1 oder 2, wobei es sich bei dem abrasiven Schlamm, der eingesetzt wird, um eine polare organische Flüssigkeit mit freien abrasiven Partikeln handelt.

4. Verfahren nach Anspruch 3, wobei es sich bei der polaren organischen Flüssigkeit um eine oder mehrere der folgenden Flüssigkeiten Polyethylenglycol (PEG), Polypropylenglycol (PPG), Co-Polymere verschiedener Polyalkylenoxide, und Polyalkylenglycol (PAG), und bei einem oder mehreren der folgenden abrasiven Partikel um Aluminiumoxid (Korund), Siliciumcarbid (SiC), Borcarbid (BC) und Galliumcarbid handelt.

5. Verfahren nach Anspruch 1 oder 2, wobei es sich bei der Alkaliverbindung, die zugesetzt wird, um ein oder mehrere Hydroxide von Alkali- oder Erdalkalimetallen wie etwa NaOH, KOH, LiOH, Ca(OH)₂, Mg(OH)₂ handelt.

6. Verfahren nach Anspruch 1 oder 2, wobei der Wafer, der eingesetzt wird, entweder mono-, mikro- oder multikristallin mit einer Dicke im Bereich von ca. 100 bis ca. 250 µm ist und aus Si oder GaAs besteht.

7. Verfahren nach einem der vorhergehenden Ansprüche, wobei der Ionengehalt auf einen Wert geregelt wird, der zu einem elektrischen Leitwert von unter 50 µS/cm führt, indem dem abrasiven Schlammgemisch nötigenfalls mehr neuwertiger abrasiver Schlamm zugesetzt wird.

8. Abrasives Schlammgemisch zur Verwenden beim Drahtsägen von Fotovoltaik-Wafern, wobei das abrasive Schlammgemisch umfasst:
- einen Teil recycelten abrasiven Schlamms,
- einen Teil Alkali; und
- einen Teil neuwertigen abrasiven Schlamms in einer Menge, die ausreicht, um einen Ionengehalt im abrasiven Schlammgemisch zum Bereitstellen eines elektrischen Leitwerts von weniger als 50 µS/cm und eines pH-Werts im abrasiven Schlammgemisch im Bereich von 6,0 bis 9,0 bereitzustellen,
- wobei es sich bei dem abrasiven Schlamm, der eingesetzt wird, um eine polare organische Flüssigkeit mit freien abrasiven Partikeln handelt, und
- wobei es sich bei der polaren organischen Flüssigkeit um eine oder mehrere der folgenden Flüssigkeiten Polyethylenglycol (PEG), Polypropylenglycol (PPG), CoPolymere verschiedener Polyalkylenoxide, und Polyalkylenglycol (PAG) handelt, und
- es sich bei den freien abrasiven Partikeln um einen oder mehrere der folgenden abrasiven Partikel handelt: Aluminiumoxid (Korund), Siliciumcarbid (SiC), Borcarbid (BC) und Galliumcarbid.

9. Abrasives Schlammgemisch nach Anspruch 8, wobei es sich bei dem pH-Wert und dem Ionengehalt des abrasiven Schlammgemischs um eine beliebige mögliche Kombination eines der folgenden pH-Bereiche von 6,0 bis 9,0; von 6,0 bis 8,0; von 6,0 bis 7,0; von 6,5 bis 9,0; von 6,5 bis 8,0; von 6,5 bis 7,0; von 7,0 bis 9,0; von 7,0 bis 8,0; von 7,0 bis 7,5; von 7,5 bis 9,0; von 7,5 bis 8,0; von 8,0 bis 9,0; und von 8,0 bis 8,5, mit einer der folgenden elektrischen Leitfähigkeiten des abrasiven Schlamms von weniger als 50 µS/cm; weniger als 45 µS/cm; weniger als 40 µS/cm; weniger als 35 µS/cm; weniger als 30 µS/cm; weniger las 25 µS/cm; und weniger als 20 µS/cm handelt.

10. Abrasives Schlammgemisch nach Anspruch 8 oder 9, wobei
- es sich bei dem abrasiven Schlamm um Polyethylenglycol mit einem durchschnittlichen Molekulargewicht von 200 Dalton und SiC-Partikeln in einer Größenverteilung F800 nach FEPA-Standard 42-2:2006 und/oder F600 nach FEPA-Standard 42-2:2006 handelt, und
- das Alkali von 10 bis 500 ppmw KOH umfasst.

## Revendications

1. Procédé pour la production de tranches photovoltaïques comprenant :
- le sciage des tranches à partir d'un bloc de matériau photovoltaïque cristallin par l'utilisation d'une scie à fil, dans lequel l'effet de sciage est fourni par le fil avec une suspension concentrée abrasive comprenant des particules abrasives et un liquide organique polaire en tant que fluide porteur et/ou de refroidissement,
- dans lequel la suspension concentrée abrasive est un mélange obtenu en mélangeant une portion d'une suspension concentrée abrasive recyclée et une portion d'une suspension concentrée abrasive nouvelle, et dans lequel
- le pH du mélange de suspension concentrée abrasive est surveillé et ajusté pour être entre 6,0 et 9,0 en ajoutant un alcali au mélange,
- la teneur ionique du mélange de suspension concentrée abrasive est régulée et surveillée en mesurant la conductance électrique du mélange de suspension concentrée abrasive, et
- la teneur ionique est régulée à une valeur conduisant à une conductance électrique inférieure à 50 µS/cm.

2. Procédé selon la revendication 1, dans lequel la quantité de la suspension concentrée abrasive recyclée, de la suspension concentrée abrasive nouvelle et du composé alcalin qui sont mélangés est ajustée pour fournir un pH et la teneur ionique de la suspension concentrée abrasive de toute combinaison possible de l'une des plages de pH suivantes de 6,0 à 9,0 ; de 6,0 à 8,0 ; de 6,0 à 7,0 ; de 6,5 à 9,0 ; de 6,5 à 8,0 ; de 6,5 à 7,0 ; de 7,0 à 9,0 ; de 7,0 à 8,0 ; de 7,0 à 7,5 ; de 7,5 à 9,0 ; de 7,5 à 8,0 ; de 8,0 à 9,0 ; et de 8,0 à 8,5, avec l'une des conductivités électriques suivantes de la suspension concentrée abrasive inférieure à 50 µS/cm ; inférieure à 45 µS/cm ; inférieure à 40 µS/cm ; inférieure à 35 µS/cm ; inférieure à 30 µS/cm ; inférieure à 25 µS/cm ; et inférieure à 20 µS/cm.

3. Procédé selon la revendication 1 ou 2, dans lequel la suspension concentrée abrasive qui est employée est un liquide organique polaire avec des particules abrasives libres.

4. Procédé selon la revendication 3, dans lequel le liquide organique polaire est un ou plusieurs des liquides suivants : polyéthylène glycol (PEG), polypropylène glycol (PPG), copolymères de divers oxydes polyalkylène, et polyalkylène glycol (PAG) et une ou plusieurs des particules abrasives suivantes : oxyde d'aluminium (corundum), carbure de silicium (SiC), carbure de bore (BC) et carbure de gallium.

5. Procédé selon la revendication 1 ou 2, dans lequel le composé alcalin qui est ajouté est un ou plusieurs hydroxydes d'un alcalin ou de métaux alcalino-terreux, comme NaOH, KOH, LiOH, Ca(OH)₂, MG(OH)₂.

6. Procédé selon la revendication 1 ou 2, dans lequel la tranche qui est employée est monocristalline, microcristalline ou multicristalline avec une épaisseur dans la plage d'environ 100 à environ 250 µm et est en Si ou GaAs.

7. Procédé selon l'une quelconque des revendications précédentes, dans lequel la teneur ionique est régulée à une valeur conduisant à une conductance électrique inférieure à 50 µS/cm en ajoutant davantage de suspension concentrée abrasive nouvelle au mélange de suspension concentrée abrasive si nécessaire.

8. Mélange de suspension concentrée abrasive destiné à être utilisé dans un sciage à fil de tranches photovoltaïques, dans lequel le mélange de suspension concentrée abrasive comprend :
- une portion d'une suspension concentrée abrasive recyclée,
- une portion d'un alcali, et
- une portion d'une suspension concentrée abrasive nouvelle en une quantité suffisante pour fournir une teneur ionique dans le mélange de suspension concentrée abrasive pour fournir une conductivité électrique inférieure à 50 µS/cm et un pH du mélange de suspension concentrée abrasive dans la plage allant de 6,0 à 9,0,
- dans lequel la suspension concentrée abrasive qui est employée est un liquide organique polaire avec des particules abrasives libres, et
- le liquide organique polaire est un ou plusieurs des liquides suivants :
polyéthylène glycol (PEG), polypropylène glycol (PPG), copolymères de divers oxydes polyalkylène, et polyalkylène glycol (PAG), et
- les particules abrasives libres sont une ou plusieurs des particules abrasives suivantes : oxyde d'aluminium (corundum), carbure de silicium (SiC), carbure de bore (BC) et carbure de gallium.

9. Mélange de suspension concentrée abrasive selon la revendication 8, dans lequel le pH et la teneur ionique de la suspension concentrée abrasive est toute combinaison possible de l'une des plages de pH suivantes de 6,0 à 9,0 ; de 6,0 à 8,0 ; de 6,0 à 7,0 ; de 6,5 à 9,0 ; de 6,5 à 8,0 ; de 6,5 à 7,0 ; de 7,0 à 9,0 ; de 7,0 à 8,0 ; de 7,0 à 7,5 ; de 7,5 à 9,0 ; de 7,5 à 8,0 ; de 8,0 à 9,0 ; et de 8,0 à 8,5, avec l'une des conductivités électriques suivantes de la suspension concentrée abrasive inférieure à 50 µS/cm ; inférieure à 45 µS/cm ; inférieure à 40 µS/cm ; inférieure à 35 µS/cm ; inférieure à 30 µS/cm ; inférieure à 25 µS/cm ; et inférieure à 20 µS/cm.

10. Mélange de suspension concentrée abrasive selon la revendication 8 ou 9, dans lequel
- la suspension concentrée abrasive est du polyéthylène glycol avec un poids moléculaire moyen de 200 Daltons et des particules de SiC dans une répartition de taille de F800 selon la norme FEPA 42-2:2006 et/ou F600 selon la norme FEPA 42-2:2006, et
- l'alcali est de 10 à 500 ppm en poids de KOH.
